# EUROPEAN PATENT APPLICATION

(11) **EP 2 750 189 A1**
(43) Date of publication of application: **02.07.2014**
(21) Application number: 13199289.3
(22) Date of filing: 23.12.2013
(51) Int. Cl.: H01L 25/10, H01L 21/56, H01L 21/98

(54) **Package on package device**

(30) Priority: 25.12.2012 CN 201220724540 U
(71) Applicant: Huawei Device Co., Ltd., Longgang District Shenzhen Guangdong 518129 (CN)
(72) Inventor: Chen, Yu, 518129 Shenzhen (CN)
(74) Representative: Pfenning, Meinig & Partner GbR

(57) **Abstract**

The present invention provides a package on package device, including: at least two components, sequentially soldered with each other, where a size of a base plate of a component located below is greater than a size of an edge of a component located above. In the package on package device provided by the present invention, the size of the base plate of the component located below is greater than the size of the edge of the component located above, so as to ensure that performing glue dispensing on the base plate of the component located below fastens the component located above, so that stability of the component located above is ensured.

## Description

### TECHNICAL FIELD

The present invention relates to a packaging technology, and in particular, to a package on package device.

### BACKGROUND

A package on package (Package on package, PoP for short) technology is applied to a component packaging process, and usually multiple layers need to be stacked on a board. For example, usually at least two components are included, and each component includes a base plate and a solder pad, a solder ball, and an electronic device that are connected to the base plate. The base plates of the two neighboring components are snapped together, the electronic devices and the solder balls are soldered, and a chip is packaged therein.

In a practical application, in order to fix a position of a bottom component on a base plate, after soldering, it is necessary to perform glue dispensing on an edge of the bottom component on the base plate, and by using fluidity of glue, the glue is filtered into each component, so as to strengthen the fastening of the electronic device in the component.

However, the stacked components are relatively high, and as a result, the glue on the base plate cannot be accumulated into the component located above. Therefore, reliability of the component located above cannot be ensured.

### SUMMARY

The present invention provides a package on package device, so as to solve the problem in the prior art of the stability of the component located on an upper layer.

In a first aspect, the present invention provides a package on package device, including: at least two components, sequentially soldered with each other, where a size of a base plate of a component located below is greater than a size of an edge of a component located above.

In a first possible implementation manner of the first aspect, an edge of the base plate of the component located below forms a protrusion upwards.

According to the first possible implementation manner of the first aspect, in a second possible implementation manner, a height of the protrusion is even with a base plate of the component located above.

With reference to the first aspect, the first possible implementation manner and the second possible implementation manner of the first aspect, in a third possible implementation manner, the number of the components is two, the component located below is an arithmetic processing chip of an access node; and the component located above is a memory storage chip.

In the package on package device provided by the present invention, a size of a base plate of a component located below is greater than a size of an edge of a component located above, so as to ensure that performing glue dispensing on the base plate of the component located below fastens the component located above, so that stability of the component located above is ensured.

### BRIEF DESCRIPTION OF DRAWINGS

FIG. 1 is a schematic structural diagram of a first embodiment of a package on package device according to the present invention; and
FIG. 2 is a schematic structural diagram of a second embodiment of a package on package device according to the present invention.

### DESCRIPTION OF EMBODIMENTS

In order to make the objectives, technical solutions, and advantages of the present invention more comprehensible, the following clearly and completely describes the technical solution in embodiments of the present invention with reference to the accompanying drawings in the embodiments of the present invention. Apparently, the described embodiments are only a part rather than all of the embodiments of the present invention. All other embodiments obtained by persons skilled in the art based on the embodiments of the present invention without creative efforts shall fall within the protection scope of the present invention.

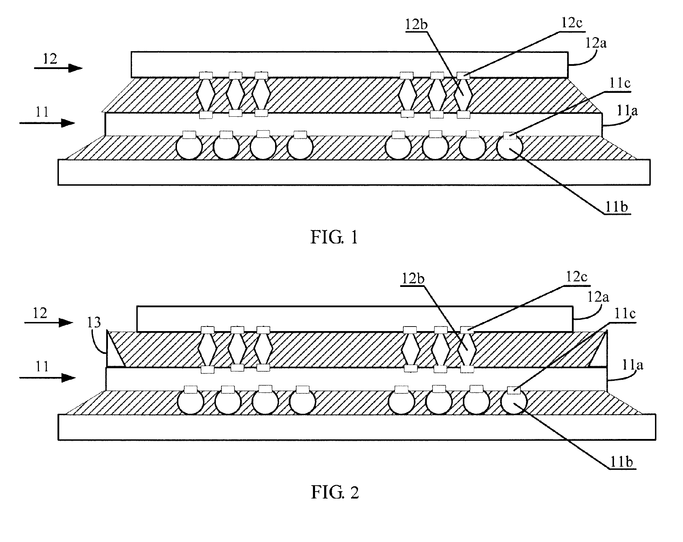

FIG. 1 is a schematic structural diagram of a first embodiment of a package on package device according to the present invention. As shown in FIG. 1, the package on package device according to the present invention includes at least two components, sequentially soldered with each other, where a size of a base plate 11a of a component 11 located below is greater than a size of an edge of a component 12 located above.

Specifically, the component located below includes a base plate 11a and a solder ball 11b located below the base plate 11 a, the solder ball 11b and the base plate 11 a are connected through a solder pad 11c, the component 12 located above includes a base plate 12a and a solder ball 12b located below the base plate 12a, and the solder ball 12b and the base plate 12a are connected through a solder pad 12c. The base plate 11 a of the component 11 located below and the base plate 12a of the component 12 located above make the solder balls melt through heating, thereby completing sequential soldering of the two components. In addition, the size of the base plate 11 a of the component 11 located below is greater than the size of the edge of the component 12 located above, and therefore glue may be dispensed on the base plate 11 a of the component 11 located below, and by using fluidity of the glue, the glue may be filtered under the base plate 12a of the component 12 located above.

Further, that the size of the base plate 11 a of the component 11 located below is greater than the size of the edge of the component 12 located above may be that the base plate 11 a of the component 11 located below is wider than the edge of the component 12 located above, may be that one edge of the base plate 11a of the component 11 located below is wider than the edge of the component 12 located above, or may be that multiple edges of the base plate 11a of the component 11 located below are wider than the edge of the component 12 located above.

In the package on package device according to the present invention, a size of a base plate of a component located below is greater than a size of an edge of a component located above, so that the component located below provides space for glue dispensing, and the component located above is stabilized in a manner of performing glue dispensing on the base plate of the component located below.

Preferably, in the package on package device described above, an edge of the base plate 11a of the component 11 located below forms a protrusion upwards. As shown in FIG. 2, FIG. 2 is a schematic structural diagram of a second embodiment of a package on package device according to the present invention.

On the basis of the foregoing embodiment, further description is given with reference to FIG. 2: An edge of the base plate 11 a of the component 11 located below forms a protrusion 13, and preferably, a height of the protrusion 13 is even with the base plate 12a of the component 12 located above. Specifically, the edge of the base plate 11a of the component 11 located below forms the protrusion 13, the protrusion 13 may ensure that dispensed glue is not scattered, so as to effectively fix the component 12 located above, and the formed protrusion 13 is even with the base plate 12a of the component 12 located above, so as to further accurately determine that a height of the glue in the base plate 11a of the component 11 located below does not exceed the base plate 12a of the component 12 located above, thereby ensuring reliability of the component 12 located above.

On the basis of the foregoing embodiment, preferably, the number of the components is two, the component located below is an arithmetic processing chip of an access node; and the component located above is a memory storage chip.

Specifically, glue dispensing is performed on the base plate of the arithmetic processing chip of the access node, so as to fix the memory storage chip located above the arithmetic processing chip of the access node.

Certainly, the number of the components is not limited. When the number of the components exceeds two, the base plate of the component of each layer may be increasingly enlarged layer by layer, so as to ensure that glue filtering retains on a component of an upper layer.

Finally, it should be noted that the foregoing embodiments are merely intended for describing the technical solutions of the present invention rather than limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of the embodiments of the present invention.

## Claims

1. A package on package device, comprising at least two components, sequentially soldered with each other, wherein
a size of a base plate of a component located below is greater than a size of an edge of a component located above.

2. The package on package device according to claim 1, wherein an edge of the base plate of the component located below forms a protrusion upwards.

3. The package on package device according to claim 2, wherein a height of the protrusion is even with a base plate of the component located above.

4. The package on package device according to any one of claims 1 to 3, wherein the number of the components is two, the component located below is an arithmetic processing chip of an access node; and the component located above is a memory storage chip.
